# EUROPÄISCHE PATENTSCHRIFT

(11) **EP 1 057 202 B1**
(45) Veröffentlichungstag und Bekanntmachung des Hinweises auf die Patenterteilung: **24.09.2008**
(21) Anmeldenummer: 99963249.0
(22) Anmeldetag: 16.11.1999
(51) Int. Cl.: H01J 37/02, H01J 37/317

(54) **VERFAHREN UND ANORDNUNG ZUR BELICHTUNG EINES SUBSTRATES**
METHOD AND DEVICE FOR EXPOSING A SUBSTRATE TO LIGHT
PROCEDE ET DISPOSITIF POUR LA SENSIBILISATION D'UN SUBSTRAT

(30) Priorität: 18.11.1998 DE 19853093
(43) Veröffentlichungstag der Anmeldung: 06.12.2000
(73) Patentinhaber: Vistec Electron Beam GmbH, 07745 Jena (DE)
(72) Erfinder: HAHMANN, Peter, D-07751 Jena-Drackendorf (DE); BEYER, Dirk, D-99423 Weimar (DE); KRAUHS, Dorothee, D-07747 Jena (DE); ELSTER, Thomas, D-07745 Jena (DE)
(74) Vertreter: Freitag, Joachim
(86) Internationale Anmeldenummer: PCT/DE1999/003639
(87) Internationale Veröffentlichungsnummer: WO 2000/030146

(56) Entgegenhaltungen:
- DE-C- 19 816 220
- PATENT ABSTRACTS OF JAPAN vol. 006, no. 185 (E-132), 21. September 1982 (1982-09-21) & JP 57 099738 A (TOSHIBA CORP), 21. Juni 1982 (1982-06-21)
- PATENT ABSTRACTS OF JAPAN vol. 1999, no. 08, 30. Juni 1999 (1999-06-30) & JP 11 067647 A (NEC CORP), 9. März 1999 (1999-03-09)
- PATENT ABSTRACTS OF JAPAN vol. 1995, no. 01, 28. Februar 1995 (1995-02-28) & JP 06 289592 A (TOPPAN PRINTING CO LTD), 18. Oktober 1994 (1994-10-18)
- PATENT ABSTRACTS OF JAPAN vol. 013, no. 530 (P-966), 27. November 1989 (1989-11-27) & JP 01 217349 A (DAINIPPON PRINTING CO LTD), 30. August 1989 (1989-08-30)
- PATENT ABSTRACTS OF JAPAN vol. 014, no. 359 (E-0959), 3. August 1990 (1990-08-03) & JP 02 125416 A (NEC CORP), 14. Mai 1990 (1990-05-14) in der Anmeldung erwähnt
- PATENT ABSTRACTS OF JAPAN vol. 016, no. 073 (E-1169), 21. Februar 1992 (1992-02-21) & JP 03 263814 A (MATSUSHITA ELECTRON CORP), 25. November 1991 (1991-11-25) in der Anmeldung erwähnt
- PATENT ABSTRACTS OF JAPAN vol. 009, no. 274 (E-354), 31. Oktober 1985 (1985-10-31) & JP 60 117720 A (FUJITSU KK), 25. Juni 1985 (1985-06-25) in der Anmeldung erwähnt
- PATENT ABSTRACTS OF JAPAN vol. 013, no. 016 (E-703), 13. Januar 1989 (1989-01-13) & JP 63 221617 A (FUJITSU LTD), 14. September 1988 (1988-09-14)

## Beschreibung

Die Erfindung bezieht sich auf ein Verfahren und eine Vorrichtung zur Belichtung eines mit einem n-schichtigen Resistsystem versehenen Substrates mit einer Korpuskularstrahlung, wobei eine elektrisch leitende Verbindung zwischen einem Massepotential und dem Substrat und dem Resistsystem zur Ableitung elektrischer Aufladungen hergestellt wird. Die Erfindung bezieht sich weiterhin auf eine Vorrichtung zum Strukturieren eines mit mehreren Schichten S₁ bis Sₙ eines Resistsystems versehenen Substrates, die einen Tisch mit einer Auflagefläche für das Substrat und Mittel zur Ableitung der sich während der Belichtung im Resistsystem ausbildenden elektrischen Aufladungen an ein Massepotential enthält und bei der eine Korpuskularstrahlung zum Zweck der Belichtung des Resistsystems eine Richtung senkrecht zu der Auflagefläche aufweist.

Es sind Verfahren und Anordnungen zur Strukturierung von Substraten, beispielsweise von Masken oder Wafern, bekannt, bei denen das Substrat mit einem Resist beschichtet ist und diese Resistschicht einer Korpuskularstrahlung, etwa einer Elektronenstrahlung, ausgesetzt wird, um dem Substrat die vorgegebene Struktur aufzuprägen. Zur Belichtung werden die Substrate auf die Auflagefläche eines in den Koordinaten X,Y verfahrbaren Tisches abgelegt und dort gehalten, während der Tisch Schritt für Schritt in Richtung X und/oder Y verschoben und dabei zeitlich nacheinander in vorgegebene Belichtungspositionen gebracht wird, in denen die Korpuskularstrahlung der Koordinate Z entsprechend rechtwinklig auf die Resistschicht gerichtet ist.

Der Resist besteht aus einem elektrisch nichtleitenden Material, das sich während der Bestrahlung elektrostatisch auflädt. Ebenso kann sich das Substrat elektrostatisch aufladen. Dieser im allgemeinen als "Charging" bezeichnete Nebeneffekt kann insbesondere bei Materialdicken der Resistschicht von > 1 µm unbeabsichtigt zur Beeinflussung der Strahlungsrichtung der Korpuskularstrahlung und damit zu Belichtungs- bzw. zu Strukturfehlern führen, was dem Bestreben der Mikroelektronikindustrie zu immer feineren Strukturen entgegenwirkt. Um dem abzuhelfen, sind verschiedene Verfahren und Anordnungen zur Ableitung der elektrischen Ladungen aus der Resistschicht und/oder aus dem Substrat während der Belichtung entwickelt worden.

Die japanische Patentschrift 01-217349 offenbart eine Vorrichtung zur Vermeidung der elektrostatischen Aufladung eines Schichtsystems beim Schreiben mit einem Elektronenstrahl. Auf dem Substrat ist eine Schicht mit einem geringen Wiederstand aufgebracht. Diese Schicht wird mit einem leitenden Stift kontaktiert, so dass die durch den Elektronenstrahl verursachte Ladung abfließen kann.

So beschreibt die Japanische Patentschrift 60-117720 ein Elektronenstrahl-Belichtungsverfahren, bei dem die elektrische Aufladung aus einer mit einer Nitrid- oder Oxid-Schicht versehenen Probe abgeleitet wird, indem eine Nadel aus einem sehr harten, zunächst elektrisch nichtleitenden Material, wie Diamant, Saphir oder dergleichen, durch Implantation von beispielsweise Bor-Ionen leitfähig gemacht und dann dazu genutzt wird, die Schicht bis zur Kontaktgabe mit der Probe zu durchstoßen. Damit wird die Erdung der Probe über die an Masse gelegte Nadel erzielt und die Ableitung der Ladung bewirkt, die sich während der Belichtung in der Probe angesammelt hat. Aufgrund der Materialhärte erreicht die Nadel eine hohe Standzeit, obwohl zum Durchstoßen der Nitrid- oder Oxid-Schicht verhältnismäßig hohe Kräfte auf die Nadel wirken müssen.

Die Vorschubbewegung der Nadel wird dabei durch das Probematerial begrenzt, das heißt die Probe bildet den Anschlag für die Nadel und verhindert deren Vordringen in das Probematerial über ein gewünschtes Maß hinaus. Nachteiligerweise ist dieses Verfahren bzw. die hier dargestellte Anordnung nur zur Kontaktierung einer unter einer Schicht verborgenen Probe geeignet, indem diese Schicht durchstoßen wird. Ist jedoch als Probe ein Substrat vorgesehen, auf das ein Resistsystem aus mehreren Schichten aufgetragen ist und soll jede der Schichten über eine separate Nadel einzeln kontaktiert und mit einem Massepotential verbunden werden, ist diese Verfahrensweise ungeeignet, da die Nadeln stets durch den gesamten Schichtaufbau hindurch bis zur Kontaktgabe mit dem Substrat gedrückt werden.

Eine weitere Japanische Patentschrift 3-263814 geht davon aus, daß es bekannt ist, beispielsweise bei einer Maskenplatine, die mit einer Chromschicht und einem über der Chromschicht liegenden Resist versehen ist, mit der Spitze eines Kontaktstiftes die Resistschicht zu durchstoßen, eine elektrisch leitende Verbindung zur darunterliegenden Chromschicht herzustellen und dabei die unerwünschten Elektronen aus der Chromschicht über den Stift an ein Massepotential abzuleiten. Dieses Verfahren wird laut Patentschrift dahingehend weiterentwickelt, daß der Kontaktstift beim Durchstoßen der Resistschicht und während der Kontaktierung mit der darunterliegenden Chromschicht in Drehung um seine Längsachse versetzt wird, um eine sichere Kontaktgabe und zugleich eine Erhöhung der Standzeit der Spitze des Kontaktstiftes zu erreichen, denn die Spitze kann nunmehr gerundet ausgeführt werden. Abgesehen von dem erhöhten gerätetechnischen Aufwand, der im Hinblick auf einen Rotationsantrieb für den Stift zu betreibenden ist, besteht auch hier der Nachteil, daß die Kontaktierung jeder einzelnen von mehreren Schichten eines Resistsystems auf diese Weise nicht vorgenommen werden kann.

In der Japanischen Patentschrift 2-125416 ist eine Anordnung zur Herstellung eines elektrischen Kontaktes zwischen einer Kassette (Massepotential) und einer Chromschicht, die auf einer Maskengrundplatte unter einem Resist liegt, dargestellt. Hierbei wird außerhalb des Gebietes, das auf der Maske der Strukturierung vorbehalten ist, ein Stift mittels einer Blattfeder auf die Oberfläche der (elektrisch nichtleitenden) Resistschicht gedrückt. Danach wird die Spitze einer Elektrode, die mit einer Hochspannungsquelle verbunden ist, in der Nähe dieses Stiftes bis auf die Chromschicht durch den Resist gedrückt und dann an die Elektrode ein Spannungspotential von einigen hundert bis zehntausend Volt gelegt, wodurch der Resist einen Isolationsdurchschlag erleidet, in dessen Folge der auf dem Resist aufliegende Stift leitend mit der Chromschicht verbunden ist und die Ableitung von Aufladungen über den Stift und die Blattfeder an die Kassette erfolgt.

Zur Kontaktierung jeder einzelnen von mehreren Schichten eines Resistsystems ist auch diese technische Lösung nicht geeignet und auch nicht vorgesehen.

Von diesem Stand der Technik ausgehend liegt der Erfindung die Aufgabe zugrunde, ein Verfahren der vorbeschriebenen Art dahingehend weiterzubilden, daß bei einem mit einem mehrschichtigen Resistsystem versehenen Substrat vor Beginn der Belichtung jede einzelne der Schichten S₁ bis Sₙ des Resistsystems und bei Bedarf auch das Substrat selbst in eine elektrisch leitende Verbindungen mit einem Massepotential gebracht wird.

Erfindungsgemäß wird die Aufgabe dadurch die Merkmale der Anspruchs 1 gelöst.

Mit diesem nicht aufwendigen Verfahrensschritt ist vorteilhaft sichergestellt, daß zwischen jeder einzelnen der Schichten S₁ bis Sₙ bzw. dem Substrat und dem Massepotential ein ohmscher Kontakt hergestellt ist, über den die während der Belichtung entstehenden elektrischen Aufladungen effektiv abgeleitet werden. Damit wird eine ungewollte Beeinflussung der Strahlungsrichtung durch elektrische Aufladungen verhindert und insofern eine wesentliche Voraussetzung für die Genauigkeit der Belichtung bzw. für eine weitere Verfeinerung der Strukturen geschaffen. Die weiter oben beschriebenen Nachteile des Standes der Technik sind damit beseitigt.

Erfindungsgemäß wird in einem einzigen Verfahrensschritt erreicht, daß beispielsweise eine Kontaktspitze K₁ bis zur Kontaktgabe mit der Schicht S₁, eine Kontaktspitze K₂ durch die Schicht S₁ hindurch bis zur Kontaktgabe mit der Schicht S₂, eine Kontaktspitze K₃ durch die Schichten S₁ und S₂ hindurch bis zur Kontaktgabe mit der Schicht S₃ usw. und schließlich eine Kontaktspitze Kₘ durch die Schichten S₁ bis Sₙ hindurch bis zur Kontaktgabe mit dem Substrat vorgeschoben werden. Die elektrischen Aufladungen aus der Schicht S₁ werden über die Kontaktspitze S₁ zum Massepotential abgeleitet, ebenso die elektrischen Aufladungen aus der Schicht S₂ über die Kontaktspitze K₂, aus der Schicht S₃ über die Kontaktspitze K₃ und aus dem Substrat über die Kontaktspitze Kₘ.

Diese Verfahrensweise hat zugleich einen weiteren vorteilhaften Effekt, der darin besteht, daß die Kontaktspitzen K₂ bis Kₘ nicht nur die Aufladungen aus den Schichten S₁ bis Sₘ ableiten, bis zu denen sie vorgeschoben sind, sondern zusätzlich auch noch aus den Schichten S₁ bis Sₘ₋₁, die sie durchstoßen haben. So werden beispielsweise durch die Kontaktspitze K₂ nicht nur die elektrischen Aufladungen aus der Schicht S₂ abgeleitet, sondern wegen des beim Durchstoßen hergestellten ohmschen Kontaktes zusätzlich auch aus der Schicht S₁. Analog trifft das für die Kontaktspitze K₃ in Bezug auf die Schichten S₁ und S₂ zu usw.

Alternativ ist es möglich, einzelnen der Schichten S₁ bis Sₙ und/oder dem Substrat nicht nur eine, sondern mehrere Kontaktspitzen zuzuordnen und so die Sicherheit der Ableitung der elektrischen Aufladung aus vorgegebenen Schichten bzw. dem Substrat zu erhöhen. Dabei kann die Kontaktierung ausgewählter Schichten bzw. des Substrates mit Hilfe mehrerer Kontaktspitzen vorgenommen werden, die an unterschiedlichen Positionen der Peripherie des Wafers oder der Maske angeordnet sind. Das ist besonders dann sinnvoll, wenn die Schichten S₁ bis Sₙ in Abschnitte segmentiert sind und die einzelnen Segmente keine elektrische Verbindung untereinander haben. Beispielsweise kann dann jedem Segment einer solchen Schicht jeweils eine Kontaktspitze zugeordnet werden.

Außerdem ist es so möglich, jeder einzelnen Schicht S₁ bis Sₙ bzw. dem Substrat in Abhängigkeit von der spezifischen Leitfähigkeit des Schichtmaterials eine Anzahl von Kontaktspitzen zuzuordnen, die mit Sicherheit die schnelle Ableitung entstehender Aufladungen aus allen Bereichen dieser Schicht gewährleistet.

Erfindungsgemäß ist die Art und Weise der Vorschubbewegung der Kontaktspitzen relativ zu dem beschichteten Substrat so vorgesehen, daß das Material der jeweils von einer Kontaktspitze zu durchdringenden Schicht entweder verdrängt oder abgetragen wird.

Die Verdrängung des Materials beim Durchstoßen einer Schicht wird dadurch erzielt, daß die Kontaktspitze unter Einwirkung einer vorgegebenen Vorschubkraft auf einer geraden Bewegungsbahn, bevorzugt in Z-Richtung, durch diese Schicht hindurchgeführt wird. Aufgrund der Keilwirkung beim Eindringen der Kontaktspitze in die jeweilige Schicht und bei ihrem weiteren Vordringen wird das Schichtmaterial seitwärts in Richtung X,Y verdrängt.

Alternativ hierzu aber ist in einer besonders bevorzugten Ausgestaltungsvariante der Erfindung vorgesehen, daß der Vorschub der Kontaktspitzen zwar im wesentlichen in Z-Richtung erfolgt, jedoch die Vorschubbewegung durch eine Komponente in Richtung der Koordinate X und/oder Y überlagert ist. Mit dieser seitwärts gerichteten Bewegungskomponente wird ein sogenannter "Kratzeffekt" beim Eindringen der Kontaktspitzen erzielt, wodurch die Schichtmaterialien mittels der Kontaktspitzen lokal begrenzt abgetragen werden und so eine innige Kontaktgabe zur freigelegten Schicht erreicht wird.

Ferner ist es Aufgabe der Erfindung eine Vorrichtung zum Strukturieren eines Substrates, das mit mehreren, ein Resistsystem bildenden Schichten S₁ bis Sₙ versehen ist, derart auszugestalten, dass Aufladungen bei der Belichtung durch eine Korpuskularstrahlung vermieden sind.

Obige Aufgabe wird durch die Merkmale des Anspruchs 5 gelöst.

Erfindungsgemäß ist bei einer derartigen Vorrichtung mindestens eine der Anzahl n der Schichten S₁ bis Sₙ entsprechende Anzahl Kontaktspitzen vorgesehen, von denen jeweils eine Kontaktspitze einer der Schichten S₁ bis Sₙ zugeordnet und jede der Kontaktspitzen über einen elektrischen Leiter mit dem Massepotential verbunden ist. Des Weiteren sind das beschichtete Substrat und die Kontaktspitzen in Richtung der Korpuskularstrahlung relativ zueinander verschieblich angeordnet, indem das beschichtete Substrat auf einer in Richtung der Korpuskularstrahlung bis zu einer Position Z₁ verschieblichen Auflageebene abgelegt, während jede der Kontaktspitzen über ein gesondertes Federelement mechanisch mit einer gestellfesten Halterung verbunden ist. Dabei ist jede Kontaktspitze unter Einwirkung einer ihr zugeordneten, durch das Federelement vorgegebenen Kraft relativ zu den übrigen Kontaktspitzen und auch relativ zur gestellfesten Halterung beweglich.

Diese erfindungsgemäße Einzelaufhängung der Kontaktspitzen an gesonderten Federelementen ermöglicht es, jeder Kontaktspitze durch entsprechende Auslegung ihres Federelementes eine spezifische Kraft beizumessen, mit der diese Kontaktspitze beim Zustellen des Substrates in die Position Z₁ auf das Resistsystem wirkt.

Außerdem ist es vorgesehen, die einzelnen Kontaktspitzen mit unterschiedlichen Geometrien in Bezug auf ihren Spitzenwinkel α und den Spitzenradius R auszubilden. Damit ist es nach bekannten Beziehungen zwischen Kraft und Fläche und unter Berücksichtigung der Dicke und Viskosität der Schichtmaterialien möglich, die Federelemente und die Spitzenradius R auszubilden. Damit ist es nach bekannten Beziehungen zwischen Kraft und Fläche und unter Berücksichtigung der Dicke und Viskosität der Schichtmaterialien möglich, die Federelemente und die Spitzengeometrie einer Kontaktspitze so aufeinander bzw. auf die Schichtmaterialien abzustimmen, daß bei der Zustellung des Substrates in die Position Z₁ eine vorgegebene Eindringtiefe in das Resistsystem erreicht wird.

Beispielhaft sind Spitzenwinkel α und Spitzenradius R einer Kontaktspitze K₁ und die ihr mit Federelement E₁ zugeordnete Kraft F₁ aufeinander und in Bezug auf die Dicke und die Viskosität einer Schicht S₁ so abzustimmen, daß beim Verschieben der Auflageebene für das Substrat bis zur Position Z₁ die Kontaktspitze K₁ die Schicht S₁ nicht durchstoßen kann, sondern lediglich auf die Schicht S₁ aufsetzt und die elektrisch leitende Verbindung zwischen der Schicht S₁ und dem mit der Kontaktspitze K₁ verbundenen Massepotential hergestellt ist.

Weiterhin ist beispielhaft vorgesehen, daß die Geometrie einer Kontaktspitze K₂ und die Kraft F₂ aufeinander und in Bezug auf die Dicke und die Viskosität der Schicht S₁ so abstimmt sind, daß beim Zustellen des Substrates in die Position Z₁ die Schicht S₁ von der Kontaktspitze K₂ durchstoßen wird und die Kontaktspitze K₂ auf der Schicht S₂ so aufsitzt, daß die elektrisch leitende Verbindung zwischen der Schicht S₂ und dem Massepotential über die Kontaktspitze K₂ hergestellt ist. Analog hierzu sind die Geometrie der Kontaktspitze K₃ und die Kraft F₃ aufeinander und in Bezug auf die Dicke und Viskosität der Schichten S₁ und S₂ so abgestimmt, daß beim Verschieben des Substrates bis zur Position Z₁ die Schichten S₁ und S₂ von der Kontaktspitze K₃ durchstoßen und die elektrisch leitende Verbindung zwischen der Schicht S₃ und dem Massepotential über die Kontaktspitze K₃ hergestellt ist.

Das gilt in derselben Weise für die weiteren Kontaktspitzen, wobei schließlich zumindest die Geometrie der Kontaktspitze Kₙ und die Kraft Fₙ aufeinander und in Bezug auf die Dicke und die Viskosität der Schichten S₁ bis Sₙ₋₁ so abgestimmt sind, daß beim Verschieben des Substrates bis zur Position Z₁ die Schichten S₁ bis Sₙ₋₁ von der Kontaktspitze Kₙ durchstoßen und die elektrisch leitende Verbindung zwischen der Schicht Sₙ und dem Massepotential über die Kontaktspitze Kₙ sichergestellt ist.

Das erfindungsgemäße Verfahren und die erfindungsgemäße Vorrichtung sind vorteilhaft anwendbar im Zusammenhang mit einem Substrat, das mit einem Resistsystem aus drei Schichten S₁ bis S₃ versehen ist, wobei die Schicht S₁ aus einem Polymer-Resist, beispielsweise der Bezeichnung PMMA, die Schicht S₂ aus Siliziumnitrid und die Schicht S₃ wiederum aus PMMA bestehen.

Eine sehr vorteilhafte Ausgestaltungsvariante der erfindungsgemäßen Vorrichtung besteht in diesem Zusammenhang darin, daß vier als Blattfedern ausgebildete Federelemente E₁, E₂ ... E₄ vorhanden sind, von denen jeweils ein Ende fest mit der Halterung verbunden ist, während jeweils am andere Ende die zugeordnete Kontaktspitze K₁, K₂ ... K₄ befestigt ist. Diesen Blattfedern können in Abhängigkeit von den Schichtmaterialien durch unterschiedliche Ausbildung des Federmaterials, des Federquerschnitts sowie der Federlänge die Eigenschaften zugemessen werden, die bei Zustellung des Substrates in die Position Z₁ Federkräfte F₁, F₂ ... F₄ erzeugen, die dafür sorgen, daß die Kontaktspitze K₁ die ihr zugeordnete Schicht S₁, die Kontaktspitze K₂ die ihr zugeordnete Schicht S₂, die Kontaktspitze K₃ die ihr zugeordnete Schicht S₃ und die Kontaktspitze K₄ das Substrat erreichen.

Die Kräfte sind dabei in einen Bereich von 0,1 Newton bis 2 Newton zu legen und die Spitzenradien der Kontaktspitzen im Bereich von 20 µm bis 100 µm auszuführen, während die Dicken der Schichten zwischen 0,5 µm und 2 µm betragen.

Die Erfindung soll nachfolgend anhand eines Ausführungsbeispieles näher erläutert werden. In den zugehörigen Zeichnungen zeigen:
- Fig. 1: ein beschichtetes Substrat vor der Kontaktierung
- Fig. 2: das beschichtete Substrat im kontaktierten Zustand
- Fig. 3: eine Draufsicht auf Substrat und Kontaktspitzen
- Fig. 4: Substrat und Kontaktspitzen in einer Seitenansicht in Richtung A aus Fig. 3
- Fig. 5: die Bewegungsbahn einer Kontaktspitze während der Kontaktierung
- Fig. 6: das Beispiel der Geometrie einer Kontakspitze im Detail

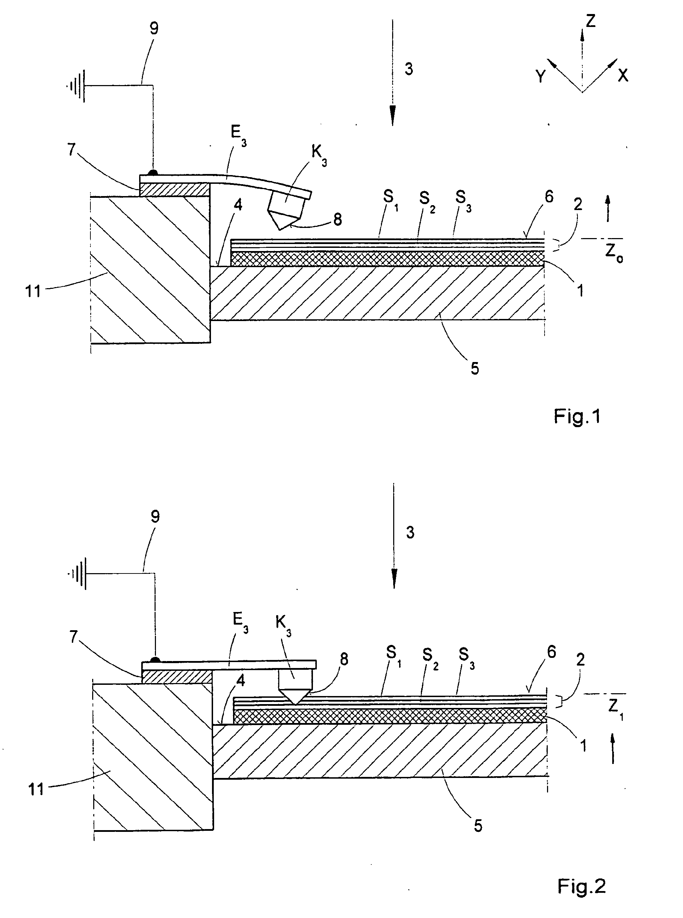

In Fig. 1 ist ausschnittweise eine Vorrichtung zum Strukturieren eines Substrates 1, das mit einem Resistsystem 2 versehen ist, dargestellt. Das beschichtete Substrat 1 ist zum Zwecke der Strukturierung mittels einer Korpuskularstrahlung, die parallel zur Koordinate Z in Richtung 3 auf das Resistsystem 2 gerichtet ist, auf der Auflageebene 4 eines Tisches 5 abgelegt.

Das Resistsystem 2 besteht aus den Schichten S₁ bis S₃, wobei als Schichtmaterial für die Schicht S₁ PMMA, für die Schicht S₂ Siliziumnitrid und für die Schicht S₃ wiederum PMMA vorgesehen sind.

Vor Beginn der Belichtung wird zunächst das Substrat 1 relativ zu einer Belichtungsoptik, die zeichnerisch nicht dargestellt ist, positioniert, indem der Tisch 5 mit dem Substrat 1 in der Koordinate Z aus einer Position Z₀ heraus verschoben wird, bis ein vorgegebener Abstand der Oberfläche 6 des Resistsystems 2 zur Belichtungsoptik eingestellt ist. Dieser Abstand sei beispielhaft mit der Position Z₁ erreicht (Fig. 2). Nach dieser Verschiebung kann der Tisch 5 mit dem Substrat 1 in Richtung der Koordinaten X und/oder Y schrittweise in die einzelnen Belichtungspositionen verschoben werden.

Um nun Aufladungen zu verhindern, durch welche die Richtung der Belichtungsstrahlung unerwünscht beeinflußt werden könnte, ist erfindungsgemäß vorgesehen, noch vor Beginn der Belichtung jede der Schichten S₁ bis S₃ und das Substrat 1 mit einem Massepotential zu verbinden, an welches die Ladungsträger ungehindert abfließen können. Diese Verbindung wird erzielt, indem die Zustellbewegung des Tisches 5 in die Position Z₁ dazu genutzt wird, jede einzelne der Schichten S₁ bis S₃ und das Substrat 1 an das Massepotential zu legen.

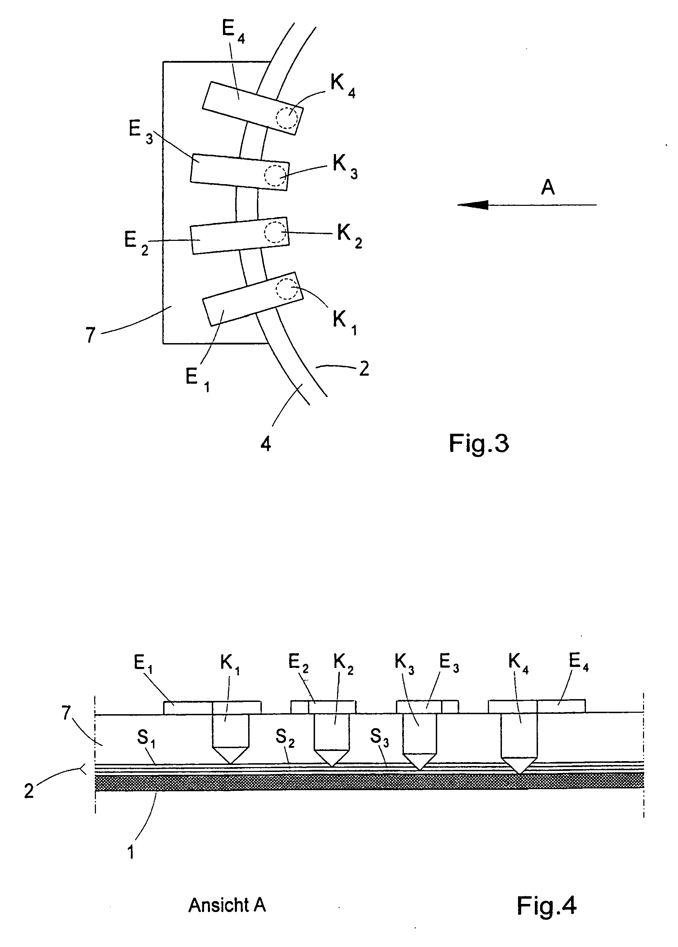

Hierzu sind in Richtung der Koordinate Z über dem Resistsystem 2 an einer gestellfesten Halterung 7 vier Kontaktspitzen K₁ bis K₄ vorgesehen, von denen jeweils eine an einem der Federelemente E₁ bis E₄ angeordnet ist, die als Blattfedern ausgebildet sind. Von den vier Kontaktspitzen K₁ bis K₄ ist die am Federelement E₁ angeordnete Kontaktspitze K₁ der Schicht S₁, die am Federelement E₂ angeordnete Kontaktspitze K₂ der Schicht S₂, die am Federelement E₃ angeordnete Kontaktspitze K₃ der Schicht S₃ und schließlich die am Federelement E₄ angeordnete Kontaktspitze K₄ dem Substrat 1 zugeordnet (Fig. 3, 4).

Der Übersichtlichkeit halber ist diese Anordnung in Fig. 1 und Fig. 2 lediglich anhand des Federelementes E₃ und der Kontaktspitze K₃ dargestellt. Hier ist zu erkennen, daß das Federelement E₃ mit einem Ende an einer Halterung 7 befestigt ist, während sich am anderen Ende freischwingend die Kontaktspitze K₃ befindet. Die Halterung 7 ist fest mit einem Gerätegestell 11 verbunden.

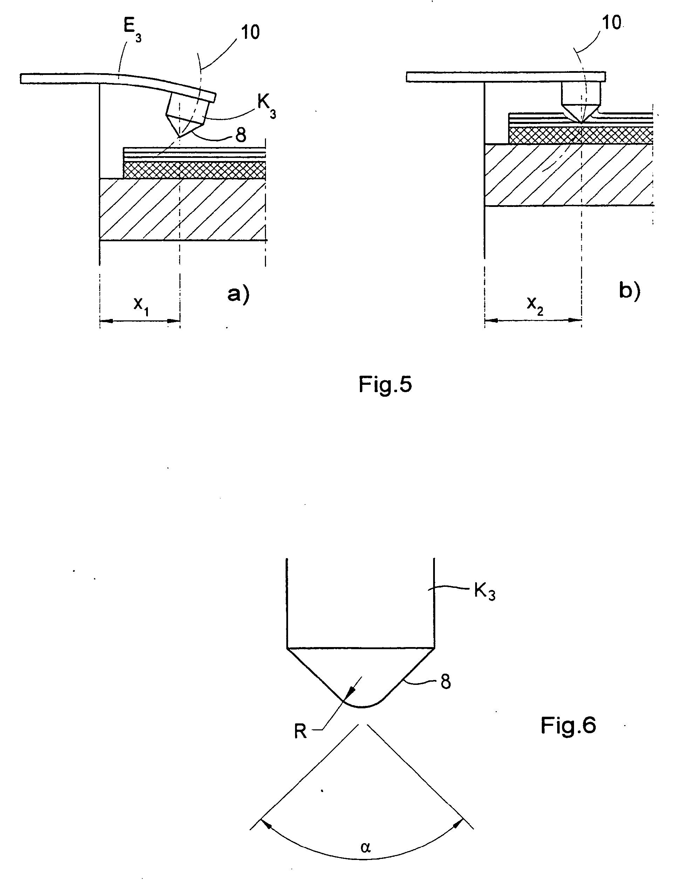

Wird nun der Tisch 5 in Richtung Z zugestellt, erreicht die Oberfläche 6 die Kontaktspitze K₃, die dabei zunächst auf die Oberfläche 6 aufsetzt, im Verlaufe der weiteren Zustellung aber vor der Oberfläche 6 hergeschoben wird. Dabei erhöht sich die Vorspannung des Federelementes E₃ und damit auch die Flächenpressung zwischen den sich berührenden Flächenabschnitten der Kontaktfläche 8 und der Oberfläche 6. Wird nun im weiteren Verlauf der Zustellung die Flächenpressung hinreichend groß, führt das zur Zerstörung der Oberfläche 6, und die Kontaktspitze K₃ dringt in die Schicht S₁ ein. Dabei ist die Eindringtiefe abhängig von der Geometrie der Kontaktspitze K₃, insbesondere von deren Spitzenwinkel α und dem Spitzenradius R (vgl. Fig. 6) sowie von den Eigenschaften des Federelementes E₃ und der Viskosität der Schicht S₁.

Bei entsprechender Abstimmung von Spitzenwinkel α, Spitzenradius R und Federelement E₃ in Bezug auf die Viskosität und Dicke der Schicht S₁ durchstößt die Kontaktspitze K₃ die Schicht S₁ und dringt in die Schicht S₂ ein. Auch hier hängt die Eindringtiefe in die Schicht S₂ von der Zunahme der Kraft ab, die sich aus der steigenden Federvorspannung bzw. Flächenpressung im Verlaufe der Zustellung ergibt. Die sich erhöhende Flächenpressung sorgt, ebenfalls wieder in Abhängigkeit von der Konsistenz und natürlich auch der Dicke der Schichten S₁ und S₂ dafür, daß auch die Schicht S₂ durchstoßen wird und die Kontaktfläche 8 in Berührung mit dem Material der Schicht S₃ tritt

Sind Spitzenwinkel α, Spitzenradius R, Federelement E₃ und Viskosität und Dicke der Schichten S₁ und S₂ hinreichend genau aufeinander abgestimmt, ist auf diese Weise eine elektrische Kontaktierung der Schicht S₃ über die Kontaktspitze K₃, das Federelement E₃ und eine elektrisch leitende Verbindung 9 an das Massepotential genau dann hergestellt, wenn die Position Z₁ erreicht ist.

Diese Konstellation ist in Fig. 2 dargestellt. Hier ist zu erkennen, daß die Kontaktfläche 8 der Kontaktspitze K₃ bis zur Schicht S₃ in das Resistsystem 2 eingedrungen ist. Dabei ist nicht nur die elektrisch leitende Verbindung zwischen der Schicht S₃ und dem Massepotential hergestellt, sondern aufgrund der Berührung der Konkaktfläche 8 mit dem Material der Schichten S₁ und S₂ sind auch diese beiden Schichten mit dem Massepotential verbunden. Setzt nun der Belichtungsprozess ein, so werden elektrische Aufladungen, die sich unerwünscht ausbilden, an das Massepotential abgeleitet.

In Fig. 3 sind in einer Draufsicht mit Blick in Richtung 3 die über Federelemente E₁ bis E₄ mit der Halterung 7 mechanisch verbundenen Kontaktspitzen K₁ bis K₄ zu erkennen. Dabei sind die Kontaktspitzen K₁ bis K₄ relativ zueinander beweglich, wobei die Bewegungsrichtung etwa der Senkrechten auf die Zeichenebene entspricht.

Fig. 4 zeigt die Federelemente E₁ bis E₄ mit den Kontaktspitzen K₁ bis K₄ in einer Ansicht in Richtung A aus Fig. 3. Hier ist zu erkennen, daß die Kontaktspitze K₁ der Schicht S₁, die Kontaktspitze K₂ der Schicht S₂, die Kontaktspitze K₃ der Schicht S₃ und die Kontaktspitze K₄ dem Substrat 1 zugeordnet ist.

Mit dieser Zuordnung ist festgelegt, daß jeweils eine der Kontaktspitzen K₁ bis K₃ die elektrische Kontaktierung einer der Schichten S₁ bis S₃ und die Kontaktspitze K₄ die elektrische Kontaktierung des Substrates 1 zu gewährleisten haben. Diesbezüglich sind die Federelemente E₁ bis E₄ und die Geometrien der Kontaktspitzen K₁ bis K₄ auf die Dicken und die Viskosität der Schichten S₁ bis S₃ so abgestimmt, daß die während der Zustellbewegung des Tisches 5 erzeugten Flächenpressungen ausreichen, jede der Kontaktspitzen K₁ bis K₃ mit der ihr jeweils zugeordneten Schicht S₁ bis S₃ und die Kontaktspitze K₄ mit dem Substrat 1 in Kontakt treten zu lassen.

Damit ist vorteilhaft erreicht, daß ohne zusätzliche mechanische (in Form von Rotationsantrieben für die Stifte) und ohne elektrische Hilfsmittel (z.B. an das Resistsystem gelegte Hochspannung) allein mit der Zustellbewegung eine sichere elektrische Verbindung jeder der Schichten S₁ bis S₃ und des Substrates 1 mit dem Massepotential gewährleistet ist.

Fig. 5 zeigt die Bewegungsbahn einer Kontaktspitze K₃ während der Kontaktierung. Da jedes Federelement E₁ bis E₄ einseitig fest eingespannt ist, bewegen sich die Kontaktspitzen K₁ bis K₄ während der Zustellung des Tisches 5 auf einem Kreisbogen 10, dessen Radius durch die jeweilige Federlänge bestimmt ist. Da aber der Tisch 5 geradegeführt ist, verändert sich die Lage der jeweiligen Berührungspunkte zwischen den Kontaktspitzen K₁ bis K₄ und dem beschichteten Substrat 1 in Richtung der Koordinaten X und Y.

Hierzu zeigt Fig. 5a) beispielsweise die Position X₁ des Berührungspunktes zwischen der Kontaktspitze K₃ und der Oberfläche 6 kurz vor dem Aufsetzen. Während des Eindringens im weiteren Verlauf der Zustellung jedoch verschiebt sich der Berührungspunkt zunehmend zur Position X₂ hin (vgl. Fig. 5b).

Diese Relativbewegung zwischen der Kontaktspitze K₃ und dem Resistsystem 2 hat zur Folge, daß die Kontaktspitze K₃ nicht geradlinig der Zustellbewegung entsprechend die Schichten S₁ und S₂ durchdringt, sondern sich beim Durchdringen sozusagen ein "Kratzeffekt" ergibt, der für eine sichere Kontaktgabe von wesentlicher Bedeutung ist. Hierdurch wird das Material der zu durchdringenden Schichten S₁ und S₂ nicht schlechthin verdrängt, sondern abgetragen, so daß mit Sicherheit ein ohmscher Kontakt zustandekommt. Dabei schiebt sich auch Schichtmaterial aus den durchdrungenen Schichten S₁ und S₂ auf die Kontaktfläche 8. Das trifft analog für die drei übrigen Kontaktspitzen K₁, K₂ und K₄ zu.

In Fig. 6 ist die Geometrie der Kontaktspitze K₃ dargestellt, die hier beispielhaft einen Spitzenradius R = 20 µm und einen Spitzenwinkel α = 30° aufweist. Damit ergibt sich unter Berücksichtigung des vorgenannten Materials der Schichten S₁ und S₂ und Schichtdicken von 1 µm bei entsprechend ausgebildetem Federelement E₃ eine Auflagekraft der Kontaktfläche 8 auf das Schichtmaterial in der Größenordnung zwischen 0,1 bis 2 Newton, die ausreichend ist, die Kontaktspitze K₃ während der Zustellbewegung die Schichten S₁ und S₂ hindurch bis zur Schicht S₃ eindringen zu lassen.

In alternativen Ausgestaltungsvarianten der Erfindung ist es selbstverständlich möglich, den Radius des Kreisbogens 10 so groß auszuführen, daß beim Durchstoßen der vorgelagerten Schichten S₁ und S₂, um beim Beispiel der Kontaktspitze K₃ zu bleiben, vorwiegend durch Materialverdrängung erfolgt. Bei hinreichend großer Federlänge des Federelementes E₃ ist die Bewegungskomponente X beim Eindringen der Kontaktspitze K₃ in das Resistsystem 2 dann so gering, daß der Kratzeffekt ausbleibt und demzufolge kein Materialabtrag, sondern lediglich eine Materialverdrängung eintritt. Auch ist eine Geradführung der Kontaktspitzen K₁ bis K₄ parallel zur Richtung 3 denkbar, wobei eines oder mehrere der Federelemente als Schraubenfedern ausgebildet sein können.

### Bezugszeichenliste

- 1: Substrat
- 2: Resistsystem
- 3: Richtung der Korpuskularstrahlung
- 4: Auflageebene
- 5: Tisch
- 6: Oberfläche des Resistsystems
- 7: Halterung
- 8: Kontaktfläche
- 9: Leiter
- 10: Kreisbogen
- 11: Gerätegestell

- S₁ - S₃: Schichten
- K₁ - K₄: Kontaktspitzen
- E₁ - E₄: Federelemente

## Patentansprüche

1. Verfahren zur Belichtung eines mit einem n-schichtigen Resistsystem (2) versehenen Substrates (1) mit einer Korpuskularstrahlung, wobei eine elektrisch leitende Verbindung zwischen einem Massepotential und dem Substrat (1) und dem Resistsystem (2) zur Ableitung elektrischer Aufladungen hergestellt wird, **dadurch gekennzeichnet, dass** in einem Verfahrensschritt vor Beginn der Belichtung das Substrat (1) und die Schichten S₁ bis Sₙ des Resistsystems (2) über eine Anzahl von m Kontaktspitzen K₁ bis Kₘ elektrisch leitend mit dem Massepotential in Verbindung gebracht werden, indem das beschichtete Substrat (1) und die Kontaktspitzen K₁ bis Kₘ relativ zueinander soweit verschoben werden, bis die elektrisch leitende Verbindung zwischen dem Massepotential und dem Substrat (1), sowie jeder einzelnen Schicht S₁ bis Sₙ über jeweils mindestens eine der Kontaktspitzen K₁ bis Kₘ hergestellt ist, wobei n>1 und m≥n+1 ist und wobei eine Kontaktspitze K₁ bis zur Kontaktgabe mit der Schicht S₁, eine Kontaktspitze K₂ durch die Schicht S₁ hindurch bis zur Kontaktgabe mit der Schicht S₂, eine Kontaktspitze K₃ durch die Schichten S₁ und S₂ hindurch bis zur Kontaktgabe mit der Schicht S₃ usw. und schließlich eine Kontaktspitze Kₘ durch die Schichten S₁ bis Sₙ hindurch bis zur Kontaktgabe mit dem Substrat (1) vorgeschoben werden.

2. Verfahren nach Anspruch 1, **dadurch gekennzeichnet, dass** einzelne der Schichten S₁ bis Sₙ und/oder das Substrat (1) über weitere Kontaktspitzen K₁ bis Kₘ, deren Anzahl der Differenz m-n entspricht, mit dem Massepotential in Verbindung gebracht werden.

3. Verfahren nach einem der vorgenannten Ansprüche, **dadurch gekennzeichnet, dass** die Vorschubbewegung der Kontaktspitzen K₁ bis Kₘ zumindest nahezu parallel zur Richtung (3) der Korpuskularstrahlung erfolgt, wobei das Material der jeweils zu durchdringenden Schichten S₁ bis Sₙ verdrängt wird, bis jede der Kontaktspitzen K₁ bis Kₘ die ihr zugeordnete Schicht S₁ bis Sₙ bzw. das Substrat (1) erreicht hat.

4. Verfahren nach einem der vorgenannten Ansprüche, **dadurch gekennzeichnet dass** die Vorschubbewegungen der einzelnen Kontaktspitzen K₁ bis Kₘ Bewegungskomponenten in den zur Richtung (3) der Korpuskularstrahlung senkrechten Koordinaten X und/oder Y aufweisen, wodurch das Material der jeweils zu durchdringenden Schichten S₁ bis Sₙ abgetragen wird, bis jede der Kontaktspitzen K₁ bis Kₘ die ihr zugeordnete Schicht S₁ bis Sₙ bzw. das Substrat (1) erreicht hat.

5. Vorrichtung zum Strukturieren eines mit mehreren Schichten S₁ bis Sₙ eines Resistsystems (2) versehenen Substrates (1), die einen Tisch (5) mit einer Auflagefläche (4) für das Substrat (1) und Mittel zur Ableitung der sich während der Belichtung im Resistsystem (2) ausbildenden elektrischen Aufladungen an ein Massepotential enthält und bei der eine Korpuskularstrahlung zum Zweck der Belichtung des Resistsystems (2) eine Richtung (3) senkrecht zu der Auflagefläche (4) aufweist, **dadurch gekennzeichnet dass**
- als Mittel zur Ableitung der elektrischen Aufladungen m Kontaktspitzen K₁ bis Kₘ vorgesehen sind, um jede der Schichten S₁ bis Sₙ und das Substrat (1) zu kontaktieren, wobei n>1 und m≥n+1 ist,
- jede Kontaktspitze K₁ bis Kₘ über eine elektrisch leitende Verbindung (9) mit dem Massepotential und über eines von mehreren Federelementen E₁ bis Eₘ mechanisch mit einer gestellfesten Halterung (7) verbunden sind, wobei jede der Kontaktspitzen K₁ bis Kₘ unter Einwirkung einer ihr zugeordneten, durch eines der Federelemente E₁ bis Eₘ vorgegebenen Kraft F₁ bis Fₘ relativ zu anderen Federelementen und zur Halterung (7) beweglich ist und dass
- die Auflageebene (4) in Richtung (3) der Korpuskularstrahlung bis zu einer Position Z₁ auf die Kontaktspitzen zu verschiebbar ist.

6. Vorrichtung nach Anspruch 5, **dadurch gekennzeichnet, dass** vier Kontaktspitzen (K₁, K₂, K₃, K₄) vorgesehen sind.

7. Vorrichtung nach Anspruch 6, **dadurch gekennzeichnet, dass** vier als Blattfedern ausgebildete Federelemente E₁ bis E₄ vorgesehen sind, von denen jeweils ein Ende mit der Halterung (7) und das gegenüberliegende Ende mit der zugeordneten Kontaktspitze K₁ bis K₄ verbunden ist.

8. Vorrichtung nach Anspruch 7, **dadurch gekennzeichnet, dass** die Federelemente E₁ bis E₄ Kräfte F₁ bis F₄ im Bereich von 0,1 bis 2 Newton ausüben, und die Kontaktflächen (8) der vier Kontaktspitzen K₁ bis K₄ mit Radien R im Bereich von 20 µm bis 100 µm versehen sind.

## Claims

1. A method for exposing a substrate (1), provided with a resist system (2) that comprises n layers, to corpuscular radiation, wherein an electroconductive connection is established between a mass potential and the substrate (1) and the resist system (2) for dissipation of electric charges, **characterized in that,** in a method step before starting exposure, an electroconductive connection is established between the substrate (1) and the layers S₁ to Sₙ of the resist system (2) via a number of m contact tips K₁ to Kₘ by displacing the coated substrate (1) and the contact tips K₁ to Kₘ relative to each other until the electroconductive connection between the mass potential and the substrate (1) as well as each individual layer S₁ to Sₙ has been established via at least one of the contact tips K₁ to Kₘ in each case, wherein n > 1 and m ≥ n + 1 and wherein a contact tip K₁ is advanced until it contacts the layer S₁, a contact tip K₂ is advanced through the layer S₁ until it contacts the layer S₂, a contact tip K₃ is advanced through the layers S₁ and S₂ until it contacts the layer S₃, etc., and finally a contact tip Kₘ is advanced through the layers S₁ to Sₙ until it contacts the substrate (1).

2. The method according to claim 1, **characterized in that** individual ones of the layers S₁ to Sₙ and/or the substrate (1) are made to contact the mass potential via further contact tips K₁ to Kₘ whose number corresponds to the difference m-n.

3. The method according to any one of the preceding claims, **characterized in that** the advancing movement of the contact tips K₁ to Kₘ is at least approximately parallel to the direction (3) of the corpuscular radiation, the material of each layer S₁ to Sₙ to be penetrated being displaced until each of the contact tips K₁ to Kₘ has reached its assigned layer S₁ to Sₙ or the substrate (1), respectively.

4. The method according to any one of the preceding claims, **characterized in that** the advancing movements of the individual contact tips K₁ to Kₘ comprise components of movement in the coordinates X and/or Y, which coordinates are perpendicular to the direction (3) of the corpuscular radiation, whereby the material of each of the layers S₁ to Sₙ to be penetrated is removed until each of the contact tips K₁ to Kₘ has reached its assigned layer S₁ to Sₙ or the substrate (1), respectively.

5. A device for structuring a substrate (1) provided with a plurality of layers S₁ to Sₙ of a resist system (2), which device includes a table (5) having a support surface (4) for the substrate (1) and means for dissipation of the electric charges forming during exposure in the resist system (2) to a mass potential and wherein corpuscular radiation for the purpose of exposure of the resist system (2) has a direction (3) perpendicular to the support surface (4), **characterized in that**
- m contact tips K₁ to Kₘ are provided as means for dissipating the electric charges in order to contact each of the layers S₁ to Sₙ and the substrate (1), wherein n > 1 and m ≥ n + 1;
- each contact tip K₁ to Kₘ is connected to the mass potential by an electrically conducting connection (9) and is mechanically connected to a support (7), fixedly mounted to a frame, via one of a plurality of spring elements E₁ to Eₘ, each of the contact tips K₁ to Kₘ being movable relative to other spring elements and to the support (7), under the influence of a force F₁ to Fₘ assigned to said contact tip and defined by one of the spring elements E₁ to Eₘ, and that
- the plane of support (4) is displaceable towards the contact tips in the direction (3) of the corpuscular radiation up to a position Z₁.

6. The device according to claim 5, **characterized in that** four contact tips (K₁, K₂, K₃, K₄) are provided.

7. The device according to claim 6, **characterized in that** four spring elements E₁ to E₄ in the form of leaf springs are provided, each of them having one end connected to the support (7) and the opposite end connected to the assigned contact tip K₁ to K₄.

8. The device according to claim 7, **characterized in that** the spring elements E₁ to E₄ exert forces F₁ to F₄ within a range of from 0.1 to 2 Newton, and the contact surfaces (8) of the four contact tips K₁ to K₄ have radiuses R within a range of from 20 µm to 100 µm.

## Revendications

1. Procédé d'exposition d'un substrat (1) à un rayonnement corpusculaire, ledit substrat (1) étant pourvu d'un système de résist (2) comprenant n couches, dans lequel procédé on établit entre un potentiel de masse et le substrat (1) et le système résist (2) une liaison électroconductrice destinée à la dissipation de charges électriques, **caractérisé en ce que,** lors d'une étape du procédé avant de commencer ladite exposition, on établit une liaison électroconductrice entre le substrat (1) et les couches S₁ à Sₙ du système de résist (2) au moyen d'un nombre m de pointes de contact K₁ à Kₘ, par déplacement relatif entre le substrat (1) enduit et les pointes de contact K₁ à Kₘ jusqu'à établir la liaison électroconductrice entre le potentiel de masse et le substrat (1) ainsi que chacune de couches S₁ à Sₙ au moyen d'au moins une des pointes de contact K₁ à Kₘ à chaque fois, où n > 1 et m ≥ n + 1, et une pointe de contact K₁ est avancée jusqu'à contacter la couche S₁, une pointe de contact K₂ est avancée à travers la couche S₁ jusqu'à contacter la couche S₂, une pointe de contact K₃ est avancée à travers les couches S₁ et S₂ jusqu'à contacter la couche S₃, etc., et finalement, une pointe de contact Kₘ est avancée à travers les couches S₁ à Sₙ jusqu'à contacter le substrat (1).

2. Procédé selon la revendication 1, **caractérisé en ce que** l'on met quelques unes des couches S₁ à Sₙ et/ou le substrat (1) en contact avec le potentiel de masse au moyen de pointes de contact additionnelles K₁ à Kₘ dont le nombre correspond à la différence m-n.

3. Procédé selon l'une quelconque des revendications précédentes, **caractérisé en ce que** l'avancement des pointes de contact K₁ à Kₘ est au moins approximativement parallèle à la direction (3) du rayonnement corpusculaire, le matériau de chaque couche S₁ à Sₙ à pénétrer étant déplacé jusqu'à ce que chacune des pointes de contact K₁ à Kₘ ait atteint respectivement sa couche associée S₁ à Sₙ ou le substrat (1).

4. Procédé selon l'une quelconque des revendications précédentes, **caractérisé en ce que** l'avancement de chacune des pointes de contact K₁ à Kₘ comprend des composantes de mouvement selon les coordonnées X et/ou Y, ces dernières étant perpendiculaires à la direction (3) du rayonnement corpusculaire, le matériau de chacune des couches S₁ à Sₙ à pénétrer étant ainsi enlevé jusqu'à ce que chacune des pointes de contact K₁ à Kₘ ait atteint respectivement sa couche associée S₁ à Sₙ ou le substrat (1).

5. Dispositif destiné à structurer un substrat (1) comprenant plusieurs couches S₁ à Sₙ d'un système de résist (2), ce dispositif comprenant une table (5) qui présente une surface d'appui (4) pour le substrat (1) et des moyens destinés à dissiper à un potentiel de masse les charges électriques se formant dans le système de résist (2) pendant l'exposition et dans lequel dispositif un rayonnement corpusculaire pour l'exposition du système de résist (2) présente une direction (3) perpendiculaire à ladite surface d'appui (4), **caractérisé en ce que**
- m pointes de contact K₁ à Kₘ sont prévues comme moyens de dissipation des charges électriques pour contacter chacune des couches S₁ à Sₙ et le substrat (1), où n > 1 et m ≥ n + 1;
- chaque pointe de contact K₁ à Kₘ est reliée au potentiel de masse au moyen d'une liaison électroconductrice (9) et est mécaniquement reliée par un de plusieurs éléments élastiques E₁ à Eₘ à un support (7) qui est monté fixe à un bâti, chacune des pointes de contact K₁ à Kₘ étant déplaçable par rapport à d'autres éléments élastiques et au support (7) sous l'influence d'une force F₁ à Fₘ associée à chaque pointe de contact et définie par un des éléments élastiques E₁ à Eₘ, et **en ce que**
- le plan d'appui (4) peut être déplacé vers les pointes de contact, dans la direction (3) du rayonnement corpusculaire, jusqu'à une position Z₁.

6. Dispositif selon la revendication 5, **caractérisé en ce que** l'on prévoit quatre pointes de contact (K₁, K₂, K₃, K₄).

7. Dispositif selon la revendication 6, **caractérisé en ce que** l'on prévoit quatre éléments élastiques E₁ à E₄ sous la forme de ressorts à lame, une extrémité de chaque élément élastique étant reliée au support (7) et l'extrémité opposée étant reliée à la pointe de contact associée K₁ à K₄.

8. Dispositif selon la revendication 7, **caractérisé en ce que** les éléments élastiques E₁ à E₄ exercent des forces F₁ à F₄ compris entre 0.1 et 2 Newton, et les surfaces de contact (8) des quatre pointes de contact K₁ à K₄ présentent des rayons R compris entre 20 µm et 100 µm.
